# EUROPÄISCHE PATENTSCHRIFT

(11) **EP 2 631 327 B1**
(45) Veröffentlichungstag und Bekanntmachung des Hinweises auf die Patenterteilung: **19.12.2018**
(21) Anmeldenummer: 13153375.4
(22) Anmeldetag: 31.01.2013
(51) Int. Cl.: C23C 14/22, C23C 4/12, C23C 14/08, C23C 14/02

(54) **Verfahren zum Aufbringen einer Wärmedämmschicht**
Method for applying a heat insulation layer
Procédé d'application d'une couche isolante

(30) Priorität: 23.02.2012 EP 12156756
(43) Veröffentlichungstag der Anmeldung: 28.08.2013
(73) Patentinhaber: Forschungszentrum Jülich GmbH, 52428 Jülich (DE); Sulzer Metco AG, 5610 Wohlen (CH)
(72) Erfinder: Hospach, Andreas, 52428 Jülich (DE); Vassen, Robert Prof. Dr., 52134 Herzogenrath (DE); Mauer, Georg Dr., 47918 Tönisvorst (DE); Rauwald, Karl-Heinz, 52428 Jülich (DE); Stöver, Detlev Prof. Dr., 52382 Niederzier (DE); von Niessen, Konstantin Dr., 5632 Buttwil (CH); Gindrat, Malko Dr., 5610 Wohlen (CH)
(74) Vertreter: Intellectual Property Services GmbH

(56) Entgegenhaltungen:
- EP-A1- 2 354 267
- US-B1- 7 838 083
- LANG R V ET AL: "DEVELOPMENT OF COMPOSITIONALLY GRADED THERMAL BARRIER COATINGS USING ION ASSISTED ELECTRON BEAM CO-EVAPORATION", INTERNATIONAL SAMPE METALS METALS PROCESSING CONFERENCE, XX, XX, 20. Oktober 1992 (1992-10-20), Seiten M266-M277, XP002034649,
- VON NIESSEN K ET AL: "Vapor phase deposition using plasma spray-PVD(TM)", JOURNAL OF THERMAL SPRAY TECHNOLOGY, ASM INTERNATIONAL, MATERIALS PARK, US, Bd. 19, Nr. 1-2, 1. Januar 2010 (2010-01-01), Seiten 502-509, XP008122397, ISSN: 1059-9630, DOI: 10.1007/S11666-009-9428-9 [gefunden am 2009-11-25]
- SHINOZAWA A ET AL: "Feather-like Structured YSZ Coatings at Fast Rates by Plasma Spray Physical Vapor Deposition", JOURNAL OF THERMAL SPRAY TECHNOLOGY, ASM INTERNATIONAL, MATERIALS PARK, US, Bd. 19, Nr. 1-2, 1. Januar 2010 (2010-01-01), Seiten 190-197, XP002623349, ISSN: 1059-9630, DOI: 10.1007/S11666-009-9410-6

## Beschreibung

### Verfahren zum Aufbringen einer Wärmedämmschicht

Die Erfindung betrifft ein Verfahren zum Aufbringen einer Wärmedämmschicht auf einer Substratoberfläche gemäss Oberbegriff von Anspruch 1

In Maschinen und Prozessen werden Wärmedämmschichten eingesetzt, um thermisch stark beanspruchte Teile gegen die Einwirkung von Hitze, Heissgaskorrosion und Erosion zu schützen. Häufig ist eine Steigerung des Wirkungsgrades von Maschinen und Prozessen nur mit einer Erhöhung der Prozesstemperatur möglich, so dass exponierte Teile entsprechend geschützt werden müssen. So werden beispielsweise die Turbinenschaufeln in Flugzeugtriebwerken und stationären Gasturbinen normalerweise mit einer Wärmedämmschicht oder einem meist mehrlagigen Wärmedämmschichtsystem versehen, um die Turbinenschaufeln gegen die Einwirkung der hohen Prozesstemperaturen zu schützen und die Wartungsintervalle und Lebensdauer zu verlängern.

Ein Wärmedämmschichtsystem kann abhängig von der Anwendung eine oder mehrere Schichten enthalten, beispielsweise eine Sperrschicht, insbesondere Diffusionssperrschicht, eine Haftvermittlungsschicht, eine Heissgaskorrosionsschutzschicht, eine Schutzschicht, eine Wärmedämmschicht und/oder eine Deckschicht. Im Beispiel der oben erwähnten Turbinenschaufeln ist das Substrat meist aus einer Ni- oder Co-Basislegierung hergestellt. Das auf der Turbinenschaufel aufgebrachte Wärmedämmschichtsystem kann zum Beispiel in aufsteigender Reihenfolge folgende Schichten enthalten:
- eine metallische Sperrschicht, zum Beispiel aus NiAl- oder NiCr- Phasen oder Legierungen,
- eine metallische Haftvermittlungsschicht, die auch als Heissgaskorrosionsschutzschicht dient, und die zum Beispiel mindestens teilweise aus einem Metallaluminid, wie beispielsweise NiAl, NiPtAI oder PtAl, oder aus einer MCrAlY-Legierung hergestellt sein kann, wobei M eines der Metalle Fe, Ni oder Co oder eine Kombination von Ni und Co bedeutet,
- eine oxidkeramische Schutzschicht, zum Beispiel zur Hauptsache aus Al₂O₃ oder aus anderen Oxiden,
- eine oxidkeramische Wärmedämmschicht, zum Beispiel aus stabilisiertem Zirkoniumoxid, und
- eine oxidkeramische Glättungs- oder Deckschicht, zum Beispiel aus stabilisiertem Zirkoniumoxid oder SiO₂.

Die Wärmedämmschicht, deren Herstellung im Folgenden beschrieben wird, enthält eine oder mehrere Lagen aus keramischem Beschichtungsmaterial. Die Wärmedämmschicht wird auf eine Substratoberfläche aufgebracht, die wie im Beispiel der oben erwähnten Turbinenschaufel durch eine metallische Haftvermittlungs- und/oder Heissgaskorrosionsschutzschicht gegeben sein kann.

Wird die oxidkeramische Wärmedämmschicht mittels atmosphärischen Plasmaspritzens (APS) aufgebracht, so erstarrt das aufgeschmolzene Beschichtungsmaterial an der Substratoberfläche und bildet in der Regel eine lamellare Schicht. Lamellare Wärmedämmschichten, welche mittels APS aufgebracht werden, haben den Nachteil, dass sie bei zyklischer, thermischer Belastung eine vergleichsweise niedrige Dehnungstoleranz aufweisen und zum Abblättern neigen.

In Dokument US 5 238 752 ist die Herstellung eines Wärmedämmschichtsystems beschrieben, das auf eine metallische Substratoberfläche aufgebracht wird. Das Substrat selbst besteht aus einer Ni- oder Co-Legierung, während die metallische Substratoberfläche durch eine 25 µm bis 125 µm dicke Haftvermittlungsschicht aus Ni- oder Pt-Aluminid gebildet wird. Auf dieser Substratoberfläche wird durch thermische Oxidation eine oxidkeramische, 0.03 µm bis 3 µm dicke Schutzschicht aus Al₂O₃ erzeugt und anschliessend mittels Electron Beam - Physical Vapor Deposition (EB-PVD) eine oxidkeramische, 125 µm bis 725 µm dicke Wärmedämmschicht aus ZrO₂ und 6% - 20% Gew. Y₂O₃ abgeschieden. Beim EB-PVD-Verfahren wird die für die Wärmedämmschicht abzuscheidende Substanz, z.B. ZrO₂ mit 8% Gew. Y₂O₃ im Hochvakuum mit einem Elektronenstrahl in die Dampfphase gebracht und aus dieser auf dem zu beschichtenden Bauteil auskondensiert. Werden die Prozessparameter geeignet gewählt, so ergibt sich eine kolumnare Mikrostruktur.

Auf Grund des kolumnaren Schichtwachstums haben die derart hergestellten Wärmedämmschichten bei zyklischer, thermischer Beanspruchung eine vergleichsweise hohe Dehnungstoleranz, so dass die Lebensdauer der Wärmedämmschichten erhöht werden kann.

Die in US 5 238 752 beschriebene Herstellung eines Wärmedämmschichtaufbaus hat jedoch den Nachteil, dass die Anlagenkosten für das Aufbringen der Wärmedämmschichten mittels EB-PVD vergleichsweise hoch sind und die Auftragsgeschwindigkeit klein ist, so dass mittels EB-PVD aufgebrachte Wärmedämmschichten vergleichsweise teuer sind.

Aus WO 03/087422 A1 ist bekannt, dass Wärmedämmschichten mit einer kolumnaren Struktur auch mittels eines LPPS-Dünnfilm-Verfahrens herstellbar sind. In dem in WO 03/087422 A1 beschriebenen Plasmaspritzverfahren wird ein zu beschichtendes Material mittels eines Plasmastrahls auf eine Oberfläche eines metallischen Substrats aufgespritzt. Dabei wird bei einem niedrigen Prozessdruck, der kleiner als 10 kPa ist, das Beschichtungsmaterial in ein den Pulverstrahl defokussierendes Plasma injiziert und dort teilweise oder vollständig geschmolzen. Hierzu wird ein Plasma mit ausreichend hoher spezifischer Enthalpie erzeugt, so dass ein substantieller, mindestens 5 Gewichts-% betragender Anteil des Beschichtungsmaterials in die Dampfphase übergeht. Auf dem Substrat wird mit dem Beschichtungsmaterial eine anisotrope strukturierte Schicht aufgetragen. In dieser Schicht sind längliche Korpuskeln, im Folgenden Kolumnen genannt, die eine anisotrope Mikrostrukturen bilden, weitgehend senkrecht zur Substratoberfläche stehend ausgerichtet, wobei die Kolumnen durch materialarme Übergangsbereiche gegeneinander abgegrenzt sind, und mithin eine kolumnare Struktur aufweisen.

Das in WO 03/087422 A1 beschriebenen Plasmaspritzverfahren zum Herstellen von Wärmedämmschichten mit kolumnarer Struktur wird im Zusammenhang mit LPPS-Dünnfilm-Verfahren erwähnt, da es wie dieselben einen breiten Plasmastrahl verwendet, der durch die Druckdifferenz zwischen dem Druck im Innern des Plasmabrenners von typisch 100 kPa und dem Druck in der Arbeitskammer von weniger als 10kPa entsteht. Da die mit dem beschriebenen Verfahren erzeugten Wärmedämmschichten jedoch bis zu 1 mm dick oder dicker sein können und damit kaum unter den Begriff "Dünnfilm" fallen, wird das beschriebene Verfahren im Folgenden als Plasma Spray - Physical Vapor Deposition-Verfahren oder kurz PS-PVD-Verfahren bezeichnet.

Aufgabe der Erfindung ist es, ein Verfahren zum Aufbringen einer Wärmedämmschicht auf einer Substratoberfläche zur Verfügung zu stellen, das gegenüber EB-PVD-Verfahren wirtschaftlicher ist, wobei die Haftfestigkeit der aufgebrachten Wärmedämmschicht auf der Substratoberfläche und die Dehnungstoleranz bei zyklischer, thermischer Belastung vergleichbar sind mit der Haftfestigkeit und Dehnungstoleranz von Wärmedämmschichten, die mittels EB-PVD-Verfahren aufgebracht wurden

Diese Aufgabe wird erfindungsgemäss durch das in Anspruch 1 definierte Verfahren.

In dem erfindungsgemässe Verfahren zum Aufbringen einer Wärmedämmschicht auf einer Substratoberfläche wird eine Arbeitskammer mit einem Plasmabrenner zur Verfügung gestellt wird, ein Plasmastrahl erzeugt, beispielsweise indem ein Plasmagas durch den Plasmabrenner geleitet und zum Beispiel mittels elektrischer Gasentladung oder elektromagnetischer Induktion oder Mikrowellen aufgeheizt wird, und der Plasmastrahl auf die Oberfläche eines in die Arbeitskammer eingebrachten Substrates gelenkt. Weiter wird in dem Verfahren mittels Plasma Spray - Physical Vapour Deposition oder kurz PS-PVD ein keramisches Beschichtungsmaterial auf die Substratoberfläche aufgebracht, wobei das Beschichtungsmaterial als Pulver in den Plasmastrahl injiziert und dort teilweise oder vollständig verdampft wird.

Zusätzlich wird beim Aufbringen der Wärmedämmschicht in einem ersten Arbeitsschritt die Zuführrate des injizierten Pulvers so eingestellt wird, dass ein Grossteil des injizierten Pulvers verdampft, insbesondere mehr als 80 Gew. % des injizierten Pulvers verdampft oder das injizierte Pulver nahezu vollständig verdampft, und/oder dass die aufgebrachte Schicht im Wesentlichen keine Splats und keine nanoskalige Cluster aufweist, wobei das Beschichtungsmaterial aus der Dampfphase auf der Substratoberfläche kondensiert, d.h. hauptsächlich als Atome und/oder Moleküle abgeschieden wird, und mit dem Material der Substratoberfläche Mischphasen bildet. Anschliessend wird in einem zweiten Arbeitsschritt die Zuführrate des injizierten Pulvers um mindestens einen Faktor 3, insbesondere um mindestens einen Faktor 5 oder mindestens einen Faktor 10 erhöht, wodurch sich der relative Anteil des injizierten Pulvers, der verdampft, verringert, und das Beschichtungsmaterial in Form von länglichen Kolumnen abgeschieden, die eine anisotrope Mikrostruktur bilden, und die im Wesentlichen senkrecht zur Substratoberfläche ausgerichtet sind.

Wenn der Anteil des injizierten Pulvers, der verdampft bzw. nanoskalige Cluster bildet, zu gering ist, beobachtet man in der Regel sogenannte Splats auf der aufgebrachten Schicht, d.h. abgegrenzte Bereiche von erstarrten Spritzern des Beschichtungsmaterials. Dieser Effekt tritt verstärkt auf, wenn als Plasmagas eine Mischung von Ar und H₂ verwendet wird.

Typisch ist die Substratoberfläche und/oder das darunterliegende Substrat metallisch, wobei das Substrat aus einer Superlegierung gefertigt sein kann, und wobei die Substratoberfläche beispielsweise durch eine Haftvermittlerschicht und/oder Heissgaskorrosionsschutzschicht, zum Beispiel eine Schicht aus einem Metallaluminid wie NiAl, NiPtAl oder PtAl oder einer Legierung des Typs MCrAlY, mit M = Fe, Co, Ni oder NiCo, gebildet werden kann. Bei Bedarf können die Haftvermittlerschicht und/oder Heissgaskorrosionsschutzschicht vor der oben beschriebenen Wärmedämmschicht mittels eines Plasmaspritzverfahrens oder eines anderen geeigneten Verfahrens auf die Substratoberfläche aufgebracht werden.

Bei Bedarf kann die Substratoberfläche durch eine Oxidschicht gebildet werden, beispielsweise durch eine thermisch Oxidschicht, die Al₂O₃ oder Al₂O₃ + Y₂O₃ enthält oder aus Al₂O₃ oder Al₂O₃ + Y₂O₃ besteht und/oder durch eine Oxidschicht, die auf einer Haftvermittlungs- und/oder Heissgaskorrosionsschutzschicht aufgebracht ist. Die Oxidschicht kann zum Beispiel thermisch in der Arbeitskammer erzeugt werden, indem in dieselbe Sauerstoff oder ein Sauerstoff enthaltendes Gas eingeleitet und die Substratoberfläche zum Beispiel durch den Plasmastrahl erwärmt wird. Mit Vorteil enthält die erzeugte Oxidschicht einen hohen Anteil an α-Al₂O₃, das bei den Einsatzbedingungen des Substrates thermisch stabil ist.

Die Oxidschicht kann auch mittels PS-PVD oder mittels eines chemischen Prozesses erzeugt werden, beispielsweise mittels Plasma Spray - Chemical Vapour Deposition (PS-CVD), wobei der Druck in der Arbeitskammer typisch unter 1 kPa liegt, und bei Bedarf mindestens eine reaktive Komponente in fester und/oder flüssiger und/oder gasförmiger Form in den Plasmastrahl injiziert wird.

Das keramische Beschichtungsmaterial enthält mit Vorteil oxidkeramische Komponenten, wobei das keramische Beschichtungsmaterial zum Beispiel aus stabilisiertem Zirkoniumoxid, beispielsweise mit Yttrium, Cer, Scandium, Dysprosium oder Gadolinium stabilisiertem Zirkoniumoxid, bestehen und/oder stabilisiertes Zirkoniumoxid, beispielsweise mit Yttrium, Cer, Scandium, Dysprosium oder Gadolinium stabilisiertes Zirkoniumoxid, als Bestandteil enthalten kann.

In einer vorteilhaften Ausführungsform des Verfahrens wird im zweiten Arbeitsschritt die Zuführrate des injizierten Pulvers stufenweise erhöht.

In einer weiteren vorteilhaften Ausführungsform beträgt die Zuführrate des injizierten Pulvers 0.5 g/min bis 5 g/min im ersten Arbeitsschritt und/oder mindestens 5 g/min, typisch 8g/min bis 30 g/min, im zweiten Arbeitsschritt.

In einer weiteren vorteilhaften Ausführungsform beträgt die Dauer des ersten Arbeitsschritts höchsten 10 %, insbesondere höchstens 5 % oder höchstens 3 %. Davon unabhängig ist es vorteilhaft, wenn die Dauer des ersten Arbeitsschritts wenigstens 0.5 %, insbesondere wenigstens 1 % oder wenigstens 2 % der Dauer des zweiten Arbeitsschritts beträgt.

In einer weiteren vorteilhaften Ausführungsform ist die während des ersten Arbeitsschritts aufgebrachte Wärmedämmschicht, welche die Mischphasen enthält 0.1 µm bis 10 µm dick ist, insbesondere 0.5 µm bis 5 µm dick.

In einer weiteren vorteilhaften Ausführungsform werden die Richtung des Plasmastrahls und/oder die Position des Plasmabrenners bezüglich dem Substrat gesteuert. Auf diese Weise kann der Plasmastrahl beim Vorheizen der Substratoberfläche oder beim Aufbringen der Wärmedämmschicht über die Substratoberfläche geführt werden.

Mit Vorteil wird die Wärmedämmschicht bei einem Druck in der Arbeitskammer von weniger als 5 kPa und typisch weniger als 2 kPa oder weniger als 1 kPa mittels PS-PVD aufgebracht, wobei das Beschichtungsmaterial meist in ein den Pulverstrahl defokussierendes Plasma injiziert wird, und wobei das Beschichtungsmaterial im Plasmastrahl wenigstens teilweise verdampft bzw. nanoskalige Cluster bildet, so dass zum Beispiel mindestens 30 Gew. % oder mindestens 50 Gew. % in die Dampfphase übergehen, um eine Wärmedämmschicht mit kolumnarer Struktur zu erzeugen.

Weiter umfasst die Erfindung ein Substrat oder Werkstück mit einer keramischen Wärmedämmschicht, welche mit dem oben beschriebenen Verfahren oder einer der oben beschriebenen Ausführungsformen und -varianten aufgebracht wurde.

Typisch ist die Substratoberfläche und/oder das darunterliegende Substrat metallisch, wobei das Substrat aus einer Superlegierung gefertigt sein kann, und wobei zwischen der Substratoberfläche und der Wärmedämmschicht eine Haftvermittlerschicht und/oder Heissgaskorrosionsschutzschicht vorgesehen sein kann, insbesondere eine Schicht aus einer Legierung des Typs MCrAlY, mit M = Fe, Co, Ni oder NiCo, oder aus einem Metallaluminid.

Bei Bedarf kann zwischen der Substratoberfläche und der Wärmedämmschicht eine Oxidschicht vorgesehen sein, beispielsweise eine thermisch Oxidschicht, die Al₂O₃ oder Al₂O₃ + Y₂O₃ enthält oder aus Al₂O₃ oder Al₂O₃ + Y₂O₃ besteht, und/oder eine Oxidschicht, die auf einer Haftvermittlungs- und/oder Heissgaskorrosionsschutzschicht aufgebracht ist.

In einer vorteilhaften Ausführungsform enthält die Wärmedämmschicht zur Substartoberfläche hin eine Zone mit Mischphasen und zur Oberfläche der Wärmedämmschicht hin eine Zone mit länglichen Kolumnen, die eine anisotrope Mikrostruktur bilden, und die im Wesentlichen senkrecht zur Substratoberfläche ausgerichtet sind, wobei die Wärmedämmschicht zum grösseren Teil aus der Zone mit länglichen Kolumnen besteht.

In einer weiteren vorteilhaften Ausführungsform hat die Zone mit Mischphasen eine Dicke von 0.1 µm bis 10 µm, vorteilhafterweise 0.5 µm bis 5 µm, und die Zone mit länglichen Kolumnen eine Dicke von 20 µm bis 2000 µm, vorteilhafterweise 100 µm bis 1500 µm.

Der entscheidende Unterschied zwischen dem oben beschriebenen Verfahren und herkömmlichen Beschichtungsverfahren liegt in der Möglichkeit, zu Beginn der Schichtabscheidung eine geringe Wachstumsrate (wie bei EB-PDV) einzustellen, und anschliessend den Grossteil der Wärmedämmschicht als kolumnare Schicht mit hoher bis sehr hoher Wachstumsrate abzuscheiden. Die langsame Schichtabscheidung zu Beginn erlaubt eine gesteigerte Anbindung der Wärmedämmschicht an die Haftvermittlerschicht oder die Oxidschicht durch die Bildung von Al₂O₃-Y₂O₃-ZrO₂-Mischphasen. Durch das Einleiten von relativ wenig Pulver (0.5 g/min bis 5 g/min) in das Plasma wird das Pulver fast vollständig verdampft, und es kommt zu einer hauptsächlichen Abscheidung von Atomen bzw. Molekülen. Die hohen Wachstumsraten erlauben eine schnelle und damit kostengünstige Schichtabscheidung. Durch das Einleiten von mehr Pulver (5 g/min bis 40 g/min) in das Plasma wird das Pulver nicht mehr vollständig verdampft und es kommt zu einer hauptsächlichen Abscheidung von 2 nm bis 20 nm grossen Clustern, aus welchen sich kolumnare Strukturen bilden. Je nach verwendeter Pulverpartikelgrösse und Plasmabrennerleistung können diese Fenster verschoben werden.

Das Verfahren zum Aufbringen einer Wärmedämmschicht und das Substrat oder Werkstück gemäss vorliegender Erfindung haben den Vorteil, dass die Wärmedämmschicht kostengünstiger aufgebracht werden kann als mit herkömmlichen EB-PVD-Verfahren, und gleichzeitig die Haftfestigkeit der aufgebrachten Wärmedämmschicht auf der Substratoberfläche und die Dehnungstoleranz bei zyklischer, thermischer Belastung gegenüber Wärmedämmschichten, die mit herkömmlichen PS-PVD Verfahren hergestellt sind, verbessert werden kann.

Die obige Beschreibung von Ausführungsformen und -varianten dient lediglich als Beispiel. Weitere vorteilhafte Ausführungsformen gehen aus den abhängigen Ansprüchen und der Zeichnung hervor. Darüber hinaus können im Rahmen der vorliegenden Erfindung auch einzelne Merkmale aus den beschriebenen oder gezeigten Ausführungsformen und -varianten miteinander kombiniert werden, um neue Ausführungsformen zu bilden.

Im Folgenden wird die Erfindung an Hand der Ausführungsbeispiele und an Hand der Zeichnung näher erläutert. Es zeigen:
- Fig. 1: ein Ausführungsbeispiel einer Plasmabeschichtungsanlage zum Aufbringen einer Wärmedämmschicht gemäss vorliegender Erfindung,
- Fig. 2: einen Querschliff durch ein Ausführungsbeispiel eines Wärmedämmschichtaufbaus mit einer Wärmedämmschicht gemäss vorliegender Erfindung nach 2700 Temperaturzyklen, und
- Fig. 3: einen Querschliff durch ein weiteres Ausführungsbeispiel eines Wärmedämmschichtaufbaus mit einer Wärmedämmschicht gemäss vorliegender Erfindung nach 1000 Temperaturzyklen.

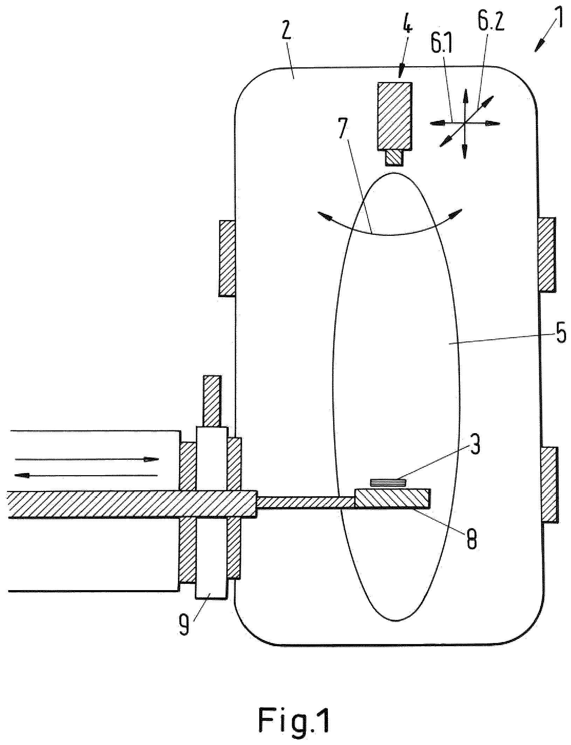

Fig. 1 zeigt ein Ausführungsbeispiel einer Plasmabeschichtungsanlage zum Aufbringen einer Wärmedämmschicht gemäss vorliegender Erfindung. Die Plasmabeschichtungsanlage 1 umfasst eine Arbeitskammer 2 mit einem Plasmabrenner 4 zur Erzeugung eines Plasmastrahls 5, eine gesteuerte Pumpvorrichtung, die in Fig. 1 nicht gezeigt ist, und die mit der Arbeitskammer 2 verbunden ist, um den Druck in der Arbeitskammer einzustellen und einen Substrathalter 8 zum Halten des Substrates 3. Der Plasmabrenner 4, der zum Beispiel als DC-Plasmabrenner ausgebildet sein kann, hat vorteilhafterweise eine zugeführte elektrische Leistung von wenigstens 60 kW, oder wenigstens 80 kW oder wenigstens 100 kW, um ein Plasma mit genügend hoher spezifischer Enthalpie zu erzeugen, so dass Wärmedämmschichten mit kolumnarer Struktur hergestellt werden können. Der Druck in der Arbeitskammer 2 ist zweckmässigerweise zwischen 2 Pa und 100 kPa oder zwischen 5 Pa und 20 kPa einstellbar. Bei Bedarf kann die Plasmabeschichtungsanlage 1 zusätzlich eine oder mehrere Injektionsvorrichtungen umfassen, um eine oder mehrere Komponenten in fester, flüssiger und/oder gasförmiger Form in das Plasma oder in den Plasmastrahl zu injizieren.

Typischerweise ist der Plasmabrenner mit einer Stromversorgung, zum Beispiel einer Gleichstromversorgung für einen DC-Plasmabrenner, und/oder mit einer Kühlvorrichtung und/oder mit einer Plasmagasversorgung verbunden und fallweise mit einer Versorgung für Spritzpulver. Das Prozess- oder Plasmagas kann beispielsweise Argon, Stickstoff, Helium oder Wasserstoff oder eine Mischung von Ar oder He mit Stickstoff und/oder Wasserstoff enthalten beziehungsweise aus einem oder mehreren dieser Gase bestehen.

In einer vorteilhaften Ausführungsvariante ist der Substrathalter 8 als verschiebbarer Stabhalter ausgeführt, um das Substrat aus einer Vorkammer durch eine Dichtungsschleuse 9 in die Arbeitskammer 2 zu bewegen. Der Stabhalter ermöglicht zusätzlich, das Substrat falls erforderlich während der Behandlung und/oder Beschichtung zu drehen.

In einer weiteren vorteilhaften Ausführungsvariante umfasst die Plasmabeschichtungsanlage 1 zusätzlich eine gesteuerte Verstellvorrichtung für den Plasmabrenner 4, die in Fig. 1 nicht gezeigt ist, um die Richtung des Plasmastrahls 5 und/oder den Abstand des Plasmabrenners vom Substrat 3 zu steuern, beispielsweise in einem Bereich von 0.2 m bis 2 m oder 0.3 m bis 1.2 m. Fallweise können in der Verstellvorrichtung eine oder mehrere Schwenkachsen vorgesehen sein, um Schwenkbewegungen 7 auszuführen. Darüber hinaus kann die Verstellvorrichtung auch zusätzliche lineare Verstellachsen 6.1, 6.2 umfassen, um den Plasmabrenner 4 über unterschiedlichen Bereichen des Substrats 3 anzuordnen. Lineare Bewegungen und Schwenkbewegungen des Plasmabrenners erlauben eine Steuerung der Substratbehandlung und -beschichtung, beispielsweise um ein Substrat über die gesamte Fläche gleichmässig vorzuheizen, oder um auf der Substratoberfläche eine gleichmässige Schichtdicke und/oder Schichtqualität zu erzielen.

Ein Ausführungsbeispiel des erfindungsgemässen Verfahrens zum Aufbringen einer Wärmedämmschicht 10 auf einer Substratoberfläche wird im Folgenden an Hand der Figuren 1, 2 und 3 beschrieben. In dem Verfahren wird eine Arbeitskammer 2 mit einem Plasmabrenner 4 zur Verfügung gestellt, ein Plasmastrahl 5 erzeugt, beispielsweise indem ein Plasmagas durch den Plasmabrenner geleitet und zum Beispiel mittels elektrischer Gasentladung oder elektromagnetischer Induktion oder Mikrowellen aufgeheizt wird, und der Plasmastrahl 5 auf die Oberfläche eines in die Arbeitskammer eingebrachten Substrates 3 gelenkt. Weiter wird in dem Verfahren mittels Plasma Spray - Physical Vapour Deposition oder kurz PS-PVD ein keramisches Beschichtungsmaterial auf die Substratoberfläche aufgebracht, wobei das Beschichtungsmaterial als Pulver in den Plasmastrahl 5 injiziert und dort teilweise oder vollständig verdampft wird.

Zusätzlich wird beim Aufbringen der Wärmedämmschicht 10 in einem ersten Arbeitsschritt die Zuführrate des injizierten Pulvers so eingestellt wird, dass ein Grossteil des injizierten Pulvers verdampft, insbesondere mehr als 80 Gew. % des injizierten Pulvers verdampft oder das injizierte Pulver nahezu vollständig verdampft, und/oder dass die aufgebrachte Schicht im Wesentlichen keine Splats bzw. nanoskalige Cluster aufweist, wobei das Beschichtungsmaterial aus der Dampfphase auf der Substratoberfläche kondensiert, d.h. hauptsächlich als Atome und/oder Moleküle abgeschieden wird, und mit dem Material der Substratoberfläche Mischphasen bildet. In einem zweiten Arbeitsschritt wird die Zuführrate des injizierten Pulvers um mindestens einen Faktor 3, insbesondere um mindestens einen Faktor 5 oder mindestens einen Faktor 10 erhöht, wodurch sich der relative Anteil des injizierten Pulvers, der verdampft, verringert, und das Beschichtungsmaterial in Form von länglichen Kolumnen abgeschieden, die eine anisotrope Mikrostruktur bilden, und die im Wesentlichen senkrecht zur Substratoberfläche ausgerichtet sind.

Typisch ist die Substratoberfläche und/oder das darunterliegende Substrat 3 metallisch, wobei das Substrat aus einer Superlegierung gefertigt sein kann, und wobei die Substratoberfläche beispielsweise durch eine Haftvermittlerschicht und/oder Heissgaskorrosionsschutzschicht 13, zum Beispiel eine Schicht aus einem Metallaluminid wie NiAl, NiPtAI oder PtAl oder einer Legierung des Typs MCrAIY, mit M = Fe, Co, Ni oder NiCo, gebildet werden kann. Bei Bedarf können die Haftvermittlerschicht und/oder Heissgaskorrosionsschutzschicht 13 vor der oben beschriebenen Wärmedämmschicht 10 mittels eines Plasmaspritzverfahrens oder eines anderen geeigneten Verfahrens auf die Substratoberfläche aufgebracht werden.

Bei Bedarf kann zur besseren Verklammerung die Oberflächenrauheit des Substrats 3 zuvor erhöht werden (z.B. durch Sandstrahlen). Nach dem Aufbringen der Haftvermittlerschicht und/oder Heissgaskorrosionsschutzschicht 13 wird die Oberflächenrauheit üblicherweise verringert (z.B. durch mechanisches Schleifen/Polieren). Zur besseren Anbindung der Haftvermittlerschicht und/oder Heissgaskorrosionsschutzschicht an dem Substrat kann dasselbe anschließend unter Vakuum (<10⁻⁴ mbar) wärmebehandelt werden (auch Diffusionsglühen genannt). Dabei werden Spannungen abgebaut, Elemente homogener verteilt und es entsteht ein chemischer Verbund zwischen Substrat und Schicht. Typisch bilden sich innerhalb der Haftvermittlerschicht und/oder Heissgaskorrosionsschutzschicht gleichmäßig verteilte β- und γ-Phasen aus und an der Oberfläche können Oxidkristalle wachsen (z.B. Y₂O₃ wenn die Haftvermittlerschicht und/oder Heissgaskorrosionsschutzschicht aus einer Legierung des Typs MCrAIY besteht).

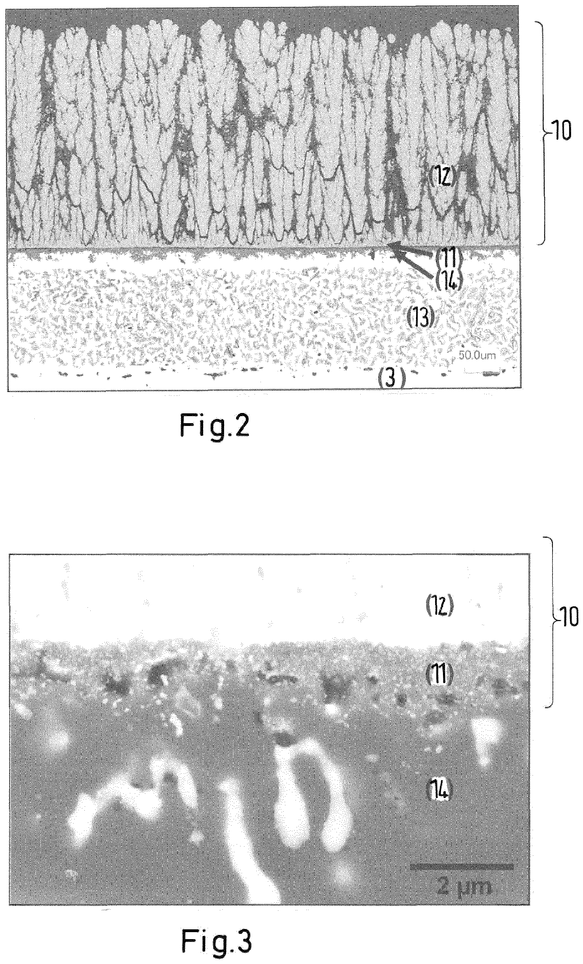

Bei Bedarf kann zudem eine Sperrschicht zwischen dem Substrat 3 und der Haftvermittlerschicht und/oder Heissgaskorrosionsschutzschicht 13 vorgesehen werden (nicht gezeigt in den Figuren 2 und 3), wobei die Sperrschicht mit Vorteil metallisch ausgebildet ist und beispielsweise NiAl oder NiCr enthalten kann.

Die Substratoberfläche kann auch durch eine Oxidschicht 14 gebildet werden, beispielsweise eine Oxidschicht, die Al₂O₃ oder Al₂O₃ + Y₂O₃ enthält oder aus Al₂O₃ oder Al₂O₃ + Y₂O₃ besteht. Vorteilhafterweise wird die Oxidschicht auf der Haftvermittlungs- und/oder Heissgaskorrosionsschutzschicht 13 aufgebracht.

Die Oxidschicht 14 kann beispielsweise thermisch in der Arbeitskammer 2 bei einer Oberflächentemperatur von 1000 °C bis 1150 °C erzeugt werden, indem Sauerstoff oder ein Sauerstoff enthaltendes Gas in die Arbeitskammer geleitet wird und die Substratoberfläche zum Beispiel durch den Plasmastrahl 5 erwärmt wird.

Dabei wächst, falls die Haftvermittlerschicht und/oder Heissgaskorrosionsschutzschicht 13 aus einer Legierung des Typs MCrAIY besteht, eine dünne, geschlossene Al₂O₃ + Y₂O₃ (auch Thermally Grown Oxide oder TGO genannt) mit einem hohen Anteil an α-Al₂O₃ auf, das bei den Einsatzbedingungen des Substrates thermisch stabil ist. Typisch wachsen dabei die während der Wärmebehandlung im Vakuum an der Oberfläche gewachsenen Y₂O₃-Kristalle sowohl in die Haftvermittlerschicht und/oder Heissgaskorrosionsschutzschicht 13 als auch in die TGO-Schicht 14 hinein und bilden längliche Stäbe. Diese enthalten im Randbereich Al₂O₃-Y₂O₃-Mischphasen und vermindern durch die Verankerung in der HV die Rissentstehung bzw. das Risswachstum zwischen der Haftvermittlerschicht und/oder Heissgaskorrosionsschutzschicht und TGO-Schicht. Die Y-Segregation in den Korngrenzen verlangsamt die Sauerstoffdiffusion und damit das TGO-Wachstum.

Die Oxidschicht 14 kann auch mittels PS-PVD oder mittels eines chemischen Prozesses erzeugt werden, beispielsweise mittels Plasma Spray - Chemical Vapour Deposition (PS-CVD), wobei der Druck in der Arbeitskammer typisch unter 1 kPa liegt, und bei Bedarf mindestens eine reaktive Komponente in fester und/oder flüssiger und/oder gasförmiger Form in den Plasmastrahl injiziert wird.

Vorteilhafterweise wird die Wärmedämmschicht 10 unmittelbar nach der Oxidschicht 14 aufgebracht, und/oder die Oxidschicht 14 wird wenigstens teilweise während des ersten Arbeitsschrittes beim Aufbringen der Wärmedämmschicht gebildet.

Das keramische Beschichtungsmaterial enthält mit Vorteil oxidkeramische Komponenten, wobei das keramische Beschichtungsmaterial zum Beispiel aus stabilisiertem Zirkoniumoxid, beispielsweise mit Seltenerden stabilisiertem Zirkoniumoxid, bestehen und/oder stabilisiertes Zirkoniumoxid als Bestandteil enthalten kann. Der als Stabilisator verwendete Stoff wird zweckmässigerweise in Form eines Oxids der Seltenerden, beispielsweise Yttrium-, Cer-, Scandium-, Dysprosium- oder Gadolinium-Oxid, dem Zirkoniumoxid beigemischt, wobei im Fall von Yttriumoxid der Anteil vorteilhafterweise 5 bis 20 Gew.-% und typisch 6 bis 10 Gew.-% beträgt.

In einer vorteilhaften Ausführungsform des Verfahrens wird im zweiten Arbeitsschritt die Zuführrate des injizierten Pulvers stufenweise erhöht.

In einer weiteren vorteilhaften Ausführungsform beträgt die Zuführrate des injizierten Pulvers 0.5 g/min bis 5 g/min im ersten Arbeitsschritt und/oder mindestens 5 g/min, typisch 8g/min bis 30 g/min oder bis 40g/min, im zweiten Arbeitsschritt.

In einer weiteren vorteilhaften Ausführungsform beträgt die Dauer des ersten Arbeitsschritts höchsten 10 %, insbesondere höchstens 5 % oder höchstens 3 %. Davon unabhängig ist es vorteilhaft, wenn die Dauer des ersten Arbeitsschritts wenigstens 0.5 %, insbesondere wenigstens 1 % oder wenigstens 2 % der Dauer des zweiten Arbeitsschritts beträgt.

In einer weiteren vorteilhaften Ausführungsform ist die während des ersten Arbeitsschritts aufgebrachte Wärmedämmschicht 10, welche die Mischphasen enthält 0.1 µm bis 10 µm dick ist, insbesondere 0.5 µm bis 5 µm dick.

In einer weiteren vorteilhaften Ausführungsform werden die Richtung des Plasmastrahls 5 und/oder die Position des Plasmabrenners 4 bezüglich dem Substrat gesteuert. Auf diese Weise kann der Plasmastrahl 10 beim Vorheizen der Substratoberfläche oder beim Aufbringen der Wärmedämmschicht über die Substratoberfläche geführt werden.

Vor dem Aufbringen und/oder Erzeugen der in den oben stehenden Ausführungsformen und -varianten beschriebenen Schichten wird das Substrat 3 und/oder die Substratoberfläche normalerweise vorgeheizt, um die Haftung der Schichten zu verbessern. Das Vorheizen des Substrats kann mittels Plasmastrahl erfolgen, wobei der Plasmastrahl 5, der zum Vorheizen weder Beschichtungspulver noch reaktive Komponenten enthält, mit Schwenkbewegungen über das Substrat geführt wird.

Mit Vorteil wird die Wärmedämmschicht 10 bei einem Druck in der Arbeitskammer von weniger als 5 kPa und typisch weniger als 2 kPa oder weniger als 1 kPa mittels PS-PVD aufgebracht, wobei das Beschichtungsmaterial meist in ein den Pulverstrahl defokussierendes Plasma injiziert wird, und wobei das Beschichtungsmaterial im Plasmastrahl wenigstens teilweise verdampft, so dass zum Beispiel mindestens 15 Gew. % oder mindestens 20 Gew. % in die Dampfphase übergehen, um eine Wärmedämmschicht mit kolumnarer Struktur zu erzeugen.

Die Wärmedämmschicht 10 kann dabei durch Abscheiden einer Mehrzahl von Lagen aufgebaut werden. Die gesamte Schichtdicke der Wärmdämmschicht 10 weist typisch Werte zwischen 50 µm und 2000 µm und vorzugsweise Werte von mindestens 100 µm auf.

Damit während des PS-PVD-Verfahrens der Pulverstrahl durch das defokussierende Plasma in eine Wolke aus Dampf und Partikeln umgeformt wird, aus der sich eine Schicht mit der angestrebten kolumnaren Struktur ergibt, müssen die Pulverpartikel des Beschichtungsmaterials sehr feinkörnig sein. Die Grössenverteilung des Beschichtungsmaterials liegt mit Vorteil zu einem wesentlichen Teil im Bereich zwischen 1 µm und 50 µm, vorzugsweise zwischen 3 µm und 25 µm, wobei die Pulverpartikel beispielsweise Agglomerate sein können, die aus Primärpartikeln von typisch 0.02 µm bis 3 µm Grösse gebildet werden.

Weiter umfasst die Erfindung ein Substrat oder Werkstück 3 mit einer keramischen Wärmedämmschicht 10, die mit dem oben beschriebenen Verfahren oder einer der oben beschriebenen Ausführungsformen und -varianten aufgebracht wurde, wobei das Substrat beispielsweise eine Turbinenschaufel aus einer Ni- oder Co-Basislegierung sein kann.

Typisch ist die Substratoberfläche und/oder das darunterliegende Substrat 3 metallisch, wobei das Substrat aus einer Superlegierung gefertigt sein kann, und wobei zwischen der Substratoberfläche und der Wärmedämmschicht 10 eine Haftvermittlerschicht und/oder Heissgaskorrosionsschutzschicht 13 vorgesehen sein kann, insbesondere eine Schicht aus einer Legierung des Typs MCrAIY, mit M = Fe, Co, Ni oder NiCo, oder aus einem Metallaluminid.

Bei Bedarf kann zwischen der Substratoberfläche und der Wärmedämmschicht 10 eine Oxidschicht 14 vorgesehen sein, beispielsweise eine thermisch Oxidschicht, die Al₂O₃ oder Al₂O₃ + Y₂O₃ enthält oder aus Al₂O₃ oder Al₂O₃ + Y₂O₃ besteht, und/oder eine Oxidschicht, die auf einer Haftvermittlungs- und/oder Heissgaskorrosionsschutzschicht 13 aufgebracht ist.

In einer vorteilhaften Ausführungsform enthält die Wärmedämmschicht 10 zur Substartoberfläche hin eine Zone 11 mit Mischphasen und zur Oberfläche der Wärmedämmschicht hin eine Zone 12 mit länglichen Kolumnen, die eine anisotrope Mikrostruktur bilden, und die im Wesentlichen senkrecht zur Substratoberfläche ausgerichtet sind, wobei die Wärmedämmschicht 10 zum grösseren Teil aus der Zone 12 mit länglichen Kolumnen besteht.

In einer weiteren vorteilhaften Ausführungsform hat die Zone 11 mit Mischphasen eine Dicke von 0.1 µm bis 10 µm, vorteilhafterweise 0.5 µm bis 5 µm, und die Zone 12 mit länglichen Kolumnen eine Dicke von 50 µm bis 2000 µm, vorteilhafterweise 100 µm bis 1500 µm.

Fig. 2 zeigt einen Querschliff durch ein Ausführungsbeispiel eines Wärmedämmschichtaufbaus mit einer Wärmedämmschicht 10 gemäss vorliegender Erfindung nach 2700 Temperaturzyklen und Fig. 3 einen Querschliff durch ein weiteres Ausführungsbeispiel nach 1000 Temperaturzyklen.

In den gezeigten Ausführungsbeispielen ist das Substrat 3 aus der Nickelbasislegierung Inconel 738 hergestellt, wobei die Substratoberfläche beispielsweise, wie in Fig. 2 gezeigt, durch eine thermische Oxidschicht 14 gebildet werden kann, die aus α-Al₂O₃ und Al₂O₃-Y₂O₃-Mischphasen besteht. Die Oxidschicht 14 ist in den gezeigten Ausführungsbeispielen auf einer Haftvermittlerschicht und/oder Heissgaskorrosionsschutzschicht 13, zum Beispiel einer Schicht aus einer Legierung des Typs MCrAIY, mit M = Fe, Co, Ni oder eine Kombination von Ni und Co aufgebracht. Die Haftvermittlerschicht und/oder Heissgaskorrosionsschutzschicht 13 hat typisch eine Dicke zwischen 50 µm und 500 µm.

Auf die Substratoberfläche wurde mit dem Verfahren gemäss vorliegender Erfindung die Wärmedämmschicht 10 aufgebracht. Diese enthält, wie in den Figuren 2 und 3 gezeigt, zur Substratoberfläche hin eine Zone 11 mit Al₂O₃-Y₂O₃-ZrO₂-Mischphasen und zur Oberfläche der Wärmedämmschicht hin eine Zone 12 mit länglichen Kolumnen, die eine anisotrope Mikrostruktur bilden, und die im Wesentlichen senkrecht zur Substratoberfläche ausgerichtet sind.

Die gezeigten Wärmedämmschichten wurden einem Temperaturzyklustest unterzogen. Dabei wird die Wärmedämmschicht im 7-Minuten-Zyklus von der Oberfläche her mit einem Brenner geheizt, bis sich die Temperatur der Wärmedämmschichtoberfläche bei 1250 °C und die Temperatur der Haftvermittlerschicht bei 1050 °C stabilisiert hat, und anschliessend die Substratrückseite mit Pressluft gekühlt, bis die Temperatur der Wärmedämmschichtoberfläche unter 100 °C gefallen ist. Gut erkennbar ist aus den Figuren 2 und 3, dass die mit dem erfindungsgemässen Verfahren aufgebrachten Wärmedämmschichten 10 nach dem Temperaturzyklustest in den in den Figuren 2 und gezeigten Bereichen intakt sind, und dass dank des oben beschriebenen Aufbaus der Wärmdämmschichten selbst nach 2700 und 1000 Temperaturzyklen keine Anzeichen von Delamination erkennbar sind.

## Patentansprüche

1. Verfahren zum Aufbringen einer Wärmedämmschicht (10) auf einer Substratoberfläche, wobei in dem Verfahren
eine Arbeitskammer (2) mit einem Plasmabrenner (4) zur Verfügung gestellt wird,
ein Plasmastrahl (5) erzeugt und auf die Oberfläche eines in die Arbeitskammer eingebrachten Substrates (3) gelenkt wird,
mittels Plasma Spray - Physical Vapour Deposition oder kurz PS-PVD ein keramisches Beschichtungsmaterial auf die Substratoberfläche aufgebracht wird, wobei das Beschichtungsmaterial als Pulver in den Plasmastrahl injiziert und dort teilweise oder vollständig verdampft wird,
**dadurch gekennzeichnet, dass**
beim Aufbringen der Wärmedämmschicht (10) in einem ersten Arbeitsschritt die Zuführrate des injizierten Pulvers so eingestellt wird, dass ein Grossteil des injizierten Pulvers verdampft,
im ersten Arbeitsschritt das Beschichtungsmaterial aus der Dampfphase auf der Substratoberfläche kondensiert und mit dem Material der Substratoberfläche Mischphasen bildet,
in einem zweiten Arbeitsschritt die Zuführrate des injizierten Pulvers um mindestens einen Faktor 3 erhöht wird, wodurch sich der relative Anteil des injizierten Pulvers, der verdampft, verringert, und im zweiten Arbeitsschritt das Beschichtungsmaterial in Form von länglichen Kolumnen abgeschieden wird, die eine anisotrope Mikrostruktur bilden, und die im Wesentlichen senkrecht zur Substratoberfläche ausgerichtet sind.

2. Verfahren nach Anspruch 1, wobei die Substratoberfläche durch eine Haftvermittlerschicht und/oder Heissgaskorrosionsschutzschicht (13) gebildet wird, insbesondere durch eine Schicht aus einer Legierung des Typs MCrAIY, mit M = Fe, Co, Ni oder NiCo, oder aus einem Metallaluminid gebildet wird.

3. Verfahren nach einem der Ansprüche 1 oder 2, wobei die Substratoberfläche durch eine Oxidschicht (14) gebildet wird, insbesondere durch eine thermische Oxidschicht, die Al₂O₃ oder Al₂O₃ + Y₂O₃ enthält oder aus Al₂O₃ oder Al₂O₃ + Y₂O₃ besteht, und/oder durch eine Oxidschicht, die auf einer Haftvermittlungs- und/oder Heissgaskorrosionsschutzschicht (13) aufgebracht ist.

4. Verfahren nach einem der Ansprüche 1 bis 3, wobei das Substrat (3) metallisch ist, insbesondere aus einer Superlegierung gefertigt ist.

5. Verfahren nach einem der Ansprüche 1 bis 4, wobei das keramische Beschichtungsmaterial oxidkeramische Komponenten enthält, und/der wobei das keramische Beschichtungsmaterial aus stabilisiertem Zirkoniumoxid, insbesondere mit Yttrium, Cer, Scandium, Dysprosium oder Gadolinium stabilisiertem Zirkoniumoxid, besteht und/oder stabilisiertes Zirkoniumoxid, insbesondere mit Yttrium, Cer, Scandium, Dysprosium oder Gadolinium stabilisiertes Zirkoniumoxid, als Bestandteil enthält.

6. Verfahren nach einem der Ansprüche 1 bis 5, wobei im zweiten Arbeitsschritt die Zuführrate des injizierten Pulvers stufenweise erhöht wird.

7. Verfahren nach einem der Ansprüche 1 bis 6, wobei im ersten Arbeitsschritt die Zuführrate des injizierten Pulvers 0.5 g/min bis 5 g/min beträgt, und/oder wobei im zweiten Arbeitsschritt die Zuführrate des injizierten Pulvers 5 g/min bis 40 g/min beträgt.

8. Verfahren nach einem der Ansprüche 1 bis 6, wobei die Dauer des ersten Arbeitsschritts höchsten 10 % oder höchsten 5 % oder höchstens 3 %, und insbesondere wenigstens 1 % oder wenigstens 2 % der Dauer des zweiten Arbeitsschritts beträgt.

9. Verfahren nach einem der vorangehenden Ansprüche, wobei die während des ersten Arbeitsschritts aufgebrachte Wärmedämmschicht, welche die Mischphasen enthält 0.1 µm bis 10 µm dick ist, insbesondere 0.5 µm bis 5 µm dick ist.

10. Verfahren nach einem der vorangehenden Ansprüche, wobei die während des ersten Arbeitsschritts aufgebrachte Wärmedämmschicht, beim Aufbringen der Wärmedämmschicht (10) in einem ersten Arbeitsschritt die Zuführrate des injizierten Pulvers so eingestellt wird, dass mehr als 80 Gew. % des injizierten Pulvers verdampft oder das injizierte Pulver nahezu vollständig verdampft, und/oder dass die aufgebrachte Schicht im Wesentlichen keine Splats und keine nanoskalige Cluster aufweist.

11. Verfahren nach einem der vorangehenden Ansprüche, wobei in einem zweiten Arbeitsschritt die Zuführrate des injizierten Pulvers um mindestens einen Faktor 5 erhöht wird.

12. Verfahren nach einem der Ansprüche 1 - 10, wobei in einem zweiten Arbeitsschritt die Zuführrate des injizierten Pulvers um mindestens einen Faktor 10 erhöht wird.

## Claims

1. A method of applying a thermal barrier coating (10) to a substrate surface, wherein in the method
a work chamber (2) having a plasma torch (4) is provided,
a plasma jet (5) is generated and is directed to the surface of a substrate (3) introduced into the work chamber,
a ceramic coating material is applied to the substrate surface by means of plasma spray physical vapor deposition or PS-PVD in abbreviation, wherein the coating material is injected into the plasma jet as a powder and is partly or completely vaporized there,
**characterized in that**
when applying the thermal barrier coating (10), the feed rate of the injected powder is set in a first work step so that a large part of the injected powder vaporizes,
in the first work step, the coating material condenses from the vapor phase on the substrate surface and forms mixed phases with the material of the substrate surface,
in a second work step, the feed rate of the injected powder is increased by at least a factor of 3, whereby the relative portion of the injected powder which vaporizes is reduced, and in the second work step, the coating material is deposited in the form of elongate columns which form an anisotropic microstructure, and which are aligned substantially perpendicular to the substrate surface.

2. A method according to claim 1, wherein the substrate surface is formed by an adhesion promoting layer and / or a hot gas corrosion protection layer (13), in particular by a layer of an alloy of the type MCrAlY, where M = Fe, Co, Ni or NiCo, or of a metallic aluminide.

3. A method according to one of the claims 1 or 2, wherein the substrate surface is formed by an oxide layer (14), in particular by a thermal oxide layer containing Al₂O₃ or AI203 + Y203 or consisting of Al₂O₃ or AI203 + Y₂O₃, and / or by an oxide layer which is applied to an adhesion promoting layer and / or to a hot gas corrosion protection layer (13).

4. A method according to anyone of the claims 1 to 3, wherein the substrate (3) is metallic, in particular made of a super alloy.

5. A method according to anyone of the claims 1 to 4, wherein the ceramic coating material contains oxide ceramic components, and / or wherein the ceramic coating material consists of stabilized zirconium oxide, in particular zirconium oxide stabilized with yttrium, cerium, scandium, dysprosium or gadolinium and / or contains stabilized zirconium oxide as a component, in particular zirconium oxide stabilized with yttrium, cerium, scandium, dysprosium or gadolinium.

6. A method according to anyone of the claims 1 to 5, wherein the feed rate of the injected powder is increased step by step in the second work step.

7. A method according to anyone of the claims 1 to 6, wherein the feed rate of the injected powder in the first work step is 0.5 g/min to 5 g/min, and / or wherein the feed rate of the injected powder in the second work step is 5 g/min to 40 g/min.

8. A method according to anyone of the claims 1 to 6, wherein the duration of the first work step is at most 10% or at most 5% or at most 3%, and in particular at least 1% or at least 2%, of the duration of the second work step.

9. A method according to anyone of the preceding claims, wherein the thermal barrier coating, which is applied during the first work step and which contains the mixed phases is 0.1 µm to 10 µm thick, in particular 0.5 µm to 5 µm thick.

10. A method according to anyone of the preceding claims, wherein the thermal barrier coating, which is applied during the first work step, when applying the thermal barrier coating (10), the feed rate of the injected powder is set in a first work step so that more than 80% per weight of the injected powder vaporizes, or the injected powder vaporizes almost completely, and / or that the applied layer has substantially no splats and no nanoscale clusters.

11. A method according to anyone of the preceding claims, wherein the feed rate of the injected powder is increased by at least a factor of 5 in a second work step.

12. A method according to anyone of the claims 1 to 10, wherein the feed rate of the injected powder is increased by at least a factor of 10 in a second work step.

## Revendications

1. Un procédé pour appliquer un revêtement de barrière thermique (10) sur la surface d'un substrat, dans quel procédé
une chambre de travail (2) avec une torche à plasma (4) est prévue,
un jet de plasma (5) est généré et dirigé sur la surface d'un substrat (3) introduit dans la chambre de travail,
un matériau de revêtement céramique est appliqué sur la surface du substrat par projection de plasma - dépôt physique par phase vapeur ou PS-PVD en abrégé, dans lequel le matériau de revêtement est injecté sous forme de poudre dans le jet de plasma où il est partiellement ou complètement évaporé,
**caractérisé en ce que**
lors de l'application du revêtement de barrière thermique (10) dans une première étape de travail, le débit d'alimentation de la poudre injectée est ajustée de telle sorte qu'une grande partie de la poudre injectée s'évapore,
dans la première étape de travail, le matériau de revêtement de la phase vapeur se condense sur la surface du substrat et forme des phases mixtes avec le matériau de la surface du substrat,
dans une seconde étape de travail, le débit d'alimentation de la poudre injectée est augmenté d'au moins un facteur 3, ce qui réduit la proportion relative de la poudre injectée qui s'évapore, et dans la seconde étape de travail, le matériau de revêtement est déposé sous forme de colonnes allongées, qui forment une microstructure anisotrope et qui sont orientés sensiblement perpendiculairement à la surface du substrat.

2. Un procédé selon la revendication 1, dans lequel la surface du substrat est formée par une couche de promoteur d'adhésion et / ou par une couche de protection contre la corrosion par gaz chaud (13), en particulier formée par une couche d'un alliage du type MCrAIY, avec M = Fe, Co, Ni ou NiCo, ou d'un aluminiure métallique.

3. Un procédé selon l'une des revendications 1 ou 2, dans lequel la surface du substrat est formée par une couche d'oxyde (14), en particulier par une couche d'oxyde thermique, qui contient Al₂O₃ ou Al₂O₃ + Y₂O₃ ou qui est constituée de Al₂O₃ ou Al₂O₃ + Y₂O₃, et / ou par une couche d'oxyde, qui est appliquée sur une couche de promoteur d'adhésion et / ou sur une couche de protection contre la corrosion par gaz chaud (13).

4. Un procédé selon l'une des revendications 1 à 3, dans lequel le substrat (3) est métallique, en particulier fait d'un superalliage.

5. Un procédé selon l'une des revendications 1 à 4, dans lequel le matériau de revêtement céramique contient des composants céramiques oxydes, et / ou dans lequel le matériau de revêtement céramique est constitué d'oxyde de zirconium stabilisé, en particulier l'oxyde de zirconium stabilisé avec de l'yttrium, du cérium, du scandium, du dysprosium ou du gadolinium et / ou de l'oxyde de zirconium stabilisé contient comme composant, en particulier l'oxyde de zirconium stabilisé avec de l'yttrium, du cérium, du scandium, du dysprosium ou du gadolinium.

6. Un procédé selon l'une des revendications 1 à 5, dans lequel le débit d'alimentation de la poudre injectée est augmentée pas à pas dans la seconde étape de travail.

7. Un procédé selon l'une des revendications 1 à 6, dans lequel le débit d'alimentation de la poudre injectée est de 0.5 g/min à 5 g/min dans la première étape de travail et / ou dans lequel le débit d'alimentation de la poudre injectée est de 5 g/min à 40 g/min dans la seconde étape de travail.

8. Un procédé selon l'une des revendications 1 à 6, dans lequel la durée de la première étape est un maximum de 10 % ou un maximum de 5 % ou un maximum de 3 %, et en particulier un minimum de 1 % ou un minimum de 2 % de la durée de la seconde étape de travail.

9. Un procédé selon l'une des revendications précédentes, dans lequel le revêtement de barrière thermique appliquée au cours de la première étape de travail, qui contient les phases mixtes, est de 0.1 µm à 10 µm d'épaisseur, en particulier de 0.5 µm à 5 µm d'épaisseur.

10. Un procédé selon l'une des revendications précédentes, dans lequel le revêtement de barrière thermique appliquée au cours de la première étape de travail, lors de l'application du revêtement de barrière thermique (10) dans une première étape de travail, le débit d'alimentation de la poudre injectée est ajustée de telle sorte que plus de 80 % en poids de la poudre injectée s'évapore ou la poudre injectée s'évapore presque complètement, et / ou que la couche appliquée n'a essentiellement pas de splats et pas de clusters nanométriques.

11. Un procédé selon l'une des revendications précédentes, dans lequel le débit d'alimentation de la poudre injectée est augmentée d'au moins un facteur 5 dans une seconde étape de travail.

12. Un procédé selon l'une des revendications 1 à 10, dans lequel le débit d'alimentation de la poudre injectée est augmentée d'au moins un facteur 10 dans une seconde étape de travail.
